# EUROPEAN PATENT APPLICATION

(11) **EP 4 421 569 A1**
(43) Date of publication of application: **28.08.2024**
(21) Application number: 22883205.1
(22) Date of filing: 25.08.2022
(51) Int. Cl.: G05B 9/02, G05B 19/048, G05B 19/18, G06F 11/00, G06F 8/654, G06F 8/71

(54) **SERVO CONTROL DEVICE**

(30) Priority: 22.10.2021 JP 2021172945
(71) Applicant: Panasonic Intellectual Property Management Co., Ltd., Kadoma-shi, Osaka 571-0057 (JP)
(72) Inventor: MATSUE, Shunsuke, Osaka 571-0057 (JP); SATO, Yuuki, Osaka 571-0057 (JP); ITO, Daisuke, Osaka 571-0057 (JP); MAEDA, Eisaku, Osaka 571-0057 (JP)
(74) Representative: SSM Sandmair
(86) International application number: PCT/JP2022/032069
(87) International publication number: WO 2023/067893

(57) **Abstract**

Preventing malfunctioning caused by an inappropriate control program. Servo control device (10) includes controller (20) that controls a target device in accordance with a control program, and power source (30) that supplies power to controller (20). Controller (20) includes first output terminal (21) that outputs a first signal when an appropriate control program is written, and outputs a second signal when an inappropriate control program is written. Servo control device (10) further includes input/output circuit (40) that receives the second signal and outputs an error signal when the second signal is output from first output terminal (21). Controller (20) further includes input terminal (22) to which an output signal from input/output circuit (40) is input, and is configured to prohibit control of the target device when the error signal is input to input terminal (22).

## Description

### TECHNICAL FIELD

The present disclosure relates to a servo control device.

### BACKGROUND ART

Conventionally, a servo control device including a controller that controls a target device has been known (for example, PTL 1). The servo control device disclosed in PTL 1 is a motor control device that controls a motor, and is configured to, when a predetermined condition is met in a power source that includes an inverter circuit, stop providing a drive signal to the inverter circuit.

### Citation List

### Patent Literature

PTL 1: Unexamined Japanese Patent Publication No. H07-143661

### SUMMARY OF THE INVENTION

A controller in a servo control device often controls a target device by operating in accordance with a control program written in the controller. If an inappropriate control program is written in the controller, the target device may malfunction due to the inappropriate control program. An object of the present disclosure is to prevent malfunctioning caused by an inappropriate control program, in such a situation.

One aspect of the present disclosure relates to a servo control device. The servo control device includes a controller that controls a target device in accordance with a control program, and a power source that supplies power to the controller. The controller further includes an input/output circuit that includes a first output terminal outputting a first signal when an appropriate control program is written and outputting a second signal when an inappropriate control program is written, and is configured to output an error signal in response to the second signal when the second signal is output from the first output terminal. The controller further includes an input terminal to which an output signal from the input/output circuit is input, and is configured to prohibit control of the target device when the error signal is input to the input terminal.

According to the present disclosure, it is possible to prevent malfunctioning caused by an inappropriate control program, proactively.

### BRIEF DESCRIPTION OF THE DRAWINGS

Fig. 1 is a block diagram illustrating an example of a servo control device according to an exemplary embodiment of the present disclosure.
Fig. 2 is a circuit diagram schematically illustrating a configuration of an input/output circuit in the servo control device according to the exemplary embodiment of the present disclosure.
Fig. 3 is a block diagram illustrating an example of a connection between a servo control device and a control target device according to the exemplary embodiment of the present disclosure.
Fig. 4 is a block diagram of an example in which a low-pass filter circuit is provided at a tip of an OR circuit in the servo control device according to the exemplary embodiment of the present disclosure.

### DESCRIPTION OF EMBODIMENT

An exemplary embodiment of a servo control device according to the present disclosure will be described with reference to some examples. However, the present disclosure is not limited to the examples described below. Although specific numerical values and materials may be provided as some examples in the description below, other numerical values and materials may be used as long as the effect of the present disclosure can be achieved.

The servo control device according to the present disclosure includes a controller, a power source, and an input/output circuit. The servo control device may be a motor control device that controls a motor, but is not limited thereto.

The controller controls the target device in accordance with a control program. The controller may include a processor and a storage for storing therein a control program that is executable by the processor. The target device may be a motor (e.g., a three-phase synchronous motor), but is not limited thereto.

The controller has a first output terminal. The first output terminal outputs a first signal when an appropriate control program is written in the controller, and outputs a second signal when an inappropriate control program is written in the controller. The first output terminal may be one of a plurality of general-purpose input/output terminals included in the controller.

The power source supplies power to the controller. The power source may also supply power to the target device. The power source may include an inverter circuit or a converter circuit.

When the second signal is output from the first output terminal, the input/output circuit receives the second signal, and outputs an error signal.

The controller further includes an input terminal to which the output signal from the input/output circuit is input. The controller is configured to prohibit the control of the target device when the error signal is input to the input terminal. The input terminal may be one of a plurality of general-purpose input/output terminals included in the controller.

In the servo control device described above, when an inappropriate control program is written in the controller, the second signal is output from the first output terminal of the controller, and input to the input/output circuit. The input/output circuit having received the second signal outputs an error signal that is, in turn, input to the input terminal of the controller. Upon receiving the error signal, the controller prohibits the control of the target device. In other words, the controller is prohibited from controlling the target device when an inappropriate control program is written. Therefore, it is possible to prevent malfunctioning of the target device caused by an inappropriate control program, proactively.

The power source may have a second output terminal that outputs a normality signal when the target device and the servo control device are operating properly, and outputs an anomaly signal when some anomaly occurs in the target device or the servo control device. The input/output circuit may be configured to, when the anomaly signal is output from the second output terminal, receive the anomaly signal, and output an error signal.

With this configuration, the input/output circuit outputs the error signal not only when the second signal is received from the controller but also when the anomaly signal is received from the power source. Therefore, when the second output terminal of the power source outputs the anomaly signal (that is, when an anomaly has occurred in the target device or the servo control device), the controller is prohibited from controlling the target device. Therefore, it is possible to avoid a situation in which the target device is controlled even though an anomaly occurs in the target device or the servo control device. The input/output circuit outputs an error signal both of when an inappropriate control program is written and when an anomaly occurs in the devices including the target device. Such an error signal is then input to the input terminal of the controller. Therefore, it is possible to execute the process for prohibiting control both of when an inappropriate control program is written and when an anomaly occurs in the devices including the target device, via one input terminal.

The input/output circuit may be configured to receive the first signal and the normality signal, and to output a non-error signal when the first signal is output from the first output terminal and the normality signal is output from the second output terminal. The controller may be configured to permit control of the target device when the non-error signal is input to the input terminal. In this configuration, when an appropriate control program is written in the controller, and the target device and the servo control device are operating properly, a non-error signal is output from the input/output circuit. The controller having received the non-error signal is allowed to control the target device.

Each of the first signal, the error signal, and the anomaly signal may be a high-level signal having a signal level higher than a predetermined level. Each of the second signal, the non-error signal, and the normality signal may be a low-level signal lower than a predetermined level. The input/output circuit may include: a NOT circuit that receives the output signal from the first output terminal and inverts the level of the output signal from the first output terminal, and outputs the inverted signal; and OR circuit that receives the output signal from the NOT circuit and the output signal from the second output terminal, and that outputs an error signal when at least one of these output signals is a high-level signal, and outputs a non-error signal when both of the output signals are low-level signals.

In this configuration, the NOT circuit outputs a low-level signal when the first signal that is a high-level signal is received, and outputs a high-level signal when the second signal that is a low-level signal is received. In other words, the NOT circuit outputs a low-level signal when an appropriate control program is written in the controller, and outputs a high-level signal when an inappropriate control program is written in the controller. The OR circuit outputs an error signal that is a high-level signal when a high-level signal (the inverted signal of the second signal or the anomaly signal) is received from at least one of the NOT circuit and the second output terminal, and outputs a non-error signal that is a low-level signal when low-level signals (the inverted signal of the first signal or the normality signal) are received from both of the NOT circuit and the second output terminal. In other words, the OR circuit outputs an error signal when an inappropriate control program is written in the controller or when an anomaly occurs in the target device or the servo control device. By contrast, when an appropriate control program is written in the controller and the target device and the servo control device are operating appropriately, the OR circuit outputs a non-error signal.

An appropriate control program may be a control program of a predetermined version or later. The inappropriate control program may be a control program of a version prior to the predetermined version. With this configuration, when a control program prior to a predetermined version is written in the controller, the input/output circuit outputs an error signal, so that the controller is prohibited from controlling the target device.

As described above, according to the present disclosure, it is possible to prevent malfunctioning of a target device caused by an inappropriate control program.

An example of the servo control device according to the present disclosure will now be specifically described with reference to some drawings. The components described above may be used as the components of the exemplary servo control device to be described below. The components of the exemplary servo control device described below may be changed based on the description above. In addition, the matters described below may be applied to the exemplary embodiment described above. Among the components of the exemplary servo control device described below, components that are not essential to the servo control device according to the present disclosure may be omitted. Note that the drawings described below are schematics and do not reflect the shapes and the numbers of actual members accurately.

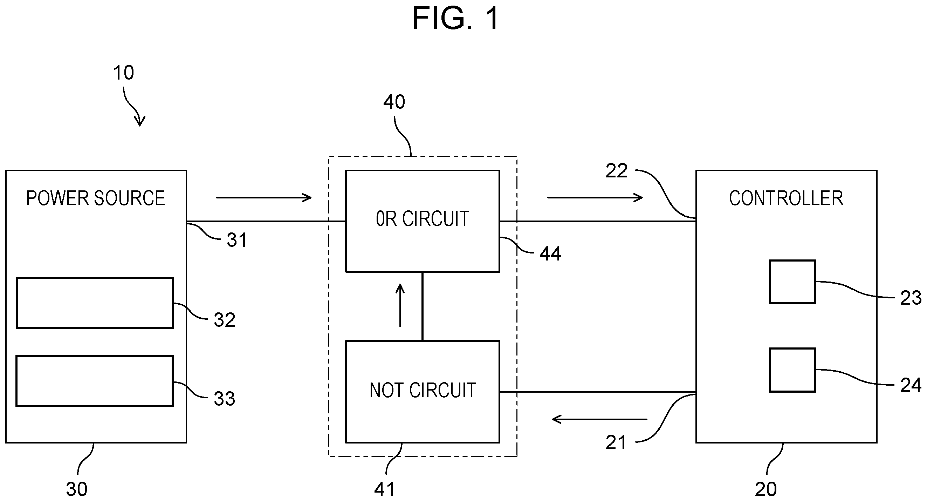

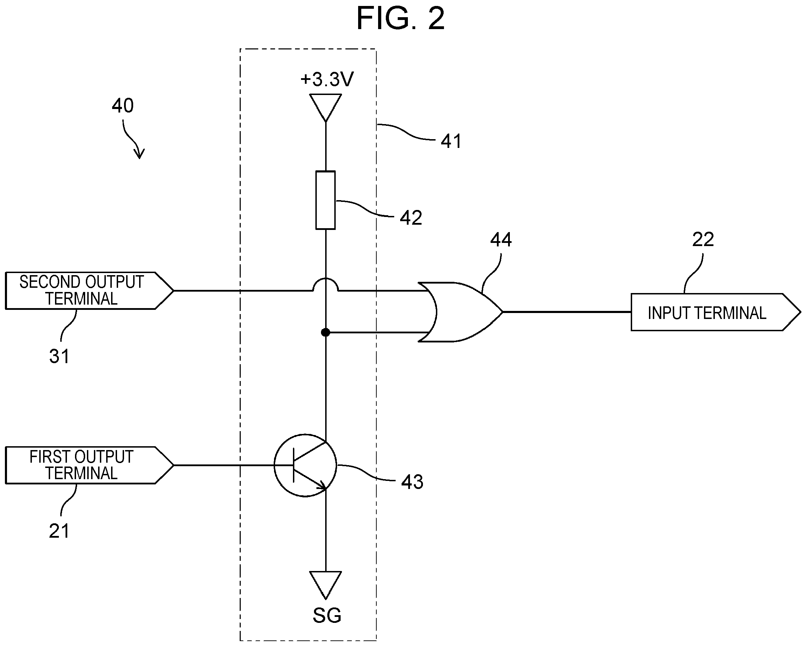

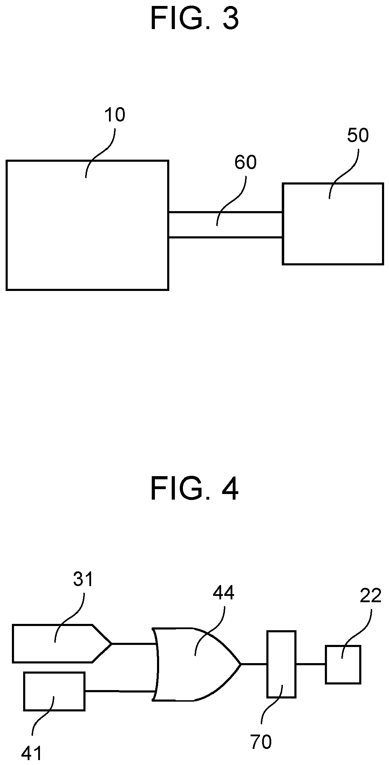

Fig. 1 is a block diagram illustrating servo control device 10 according to an exemplary embodiment. Fig. 2 is a circuit diagram schematically illustrating a configuration of input/output circuit 40 in servo control device 10 according to the present exemplary embodiment. Fig. 3 is a block diagram illustrating a connection between servo control device 10 according to the present exemplary embodiment and motor 50 that is an example of a control target device. Fig. 4 is a block diagram of an example in which low-pass filter circuit 70 is provided at the tip of OR circuit 44 in servo control device 10 according to the present exemplary embodiment.

Servo control device 10 according to the present exemplary embodiment is a motor control device that controls motor 50 as the target device as illustrated in Fig. 3, but is not limited thereto. As illustrated in Figs. 1 and 2, servo control device 10 includes controller 20, power source 30, and input/output circuit 40. Servo control device 10 and motor 50 are connected to each other via cable 60.

Controller 20 controls motor 50 in accordance with a control program. Controller 20 includes processor 23 and storage 24 storing therein a control program that is executable by processor 23.

Controller 20 includes first output terminal 21. First output terminal 21 outputs the first signal (high-level signal) when an appropriate control program (for example, a control program of a predetermined version or a version later than the predetermined version) is written in controller 20, and outputs the second signal (low-level signal) when an inappropriate control program (for example, a control program of a version prior to the predetermined version) is written in controller 20.

Power source 30 is a power board that supplies power to controller 20 and motor 50. Power source 30 includes inverter circuit 32 and converter circuit 33.

Power source 30 includes second output terminal 31 that outputs a normality signal (low-level signal) when the motor and servo control device 10 are normal, and outputs an anomaly signal (high-level signal) when an anomaly occurs in the motor or servo control device 10.

When the second signal is output from first output terminal 21, input/output circuit 40 receives the second signal, and outputs an error signal (high-level signal). When an anomaly signal is output from second output terminal 31, input/output circuit 40 receives the anomaly signal, and outputs an error signal. When the first signal is output from first output terminal 21, and the normality signal is output from second output terminal 31, input/output circuit 40 receives the first signal and the normality signal, and outputs a non-error signal (low-level signal).

As illustrated in Fig. 2, input/output circuit 40 includes NOT circuit 41 and OR circuit 44. NOT circuit 41 receives the output signal (the first signal or the second signal) from first output terminal 21, inverts the level of the output signal, and outputs the inverted signal. Specifically, NOT circuit 41 includes pull-up resistor 42 and transistor 43. The output signal from first output terminal 21 is input to the base of transistor 43. When first output terminal 21 outputs the first signal (high-level signal), transistor 43 transits to a conductive state, and the potential of an output line of NOT circuit 41 is brought to the same level as the ground (SG). As a result, the output of NOT circuit 41 is switched to a low-level signal. By contrast, when first output terminal 21 outputs the second signal (low-level signal), the transistor transits to a non-conductive state, and the potential of the output line of NOT circuit 41 is brought to the same level as a +3.3 V power line. As a result, the output of NOT circuit 41 is switched to a high-level signal. Note that the potential of the power supply line is not limited to +3.3 V.

OR circuit 44 receives an output signal from NOT circuit 41 and an output signal from second output terminal 31. OR circuit 44 outputs an error signal when at least one of the output signals is a high-level signal, and outputs a non-error signal when both of the output signals are low-level signals. In other words, when an inappropriate control program is written in controller 20 or when an anomaly occurs in motor 50 or servo control device 10, OR circuit 44 outputs an error signal. By contrast, when an appropriate control program is written in controller 20 and the motor and servo control device 10 are operating properly, OR circuit 44 outputs a non-error signal. As illustrated in Fig. 4, low-pass filter circuit 70 may be provided to an output line of OR circuit 44.

Controller 20 further includes input terminal 22 to which the output signal from input/output circuit 40 is input. Controller 20 is configured to prohibit the control of the motor when an error signal is input to input terminal 22, and to permit the control of the motor when a non-error signal is input to input terminal 22. That is, the control of the motor by controller 20 is permitted only when an appropriate control program is written in controller 20 and the motor and servo control device 10 are operating properly. Therefore, it is possible to prevent malfunctioning of the motor caused by an inappropriate control program proactively. To prohibit the control of the motor, controller 20 brings all of switching elements of the inverter circuit included in power source 30 to the non-conductive state, for example.

Note that, in the present exemplary embodiment, an example in which servo control device 10 is connected to motor 50 that is the target device via cable 60 has been described. However, the invention according to the present disclosure is not limited thereto, and servo control device 10 may be incorporated in the target device, and connected by wiring internal of the target device, or servo control device 10 and the target device may be connected wirelessly.

### INDUSTRIAL APPLICABILITY

The present disclosure can be used in a servo control device.

### REFERENCE MARKS IN THE DRAWINGS

- 10:: servo control device
- 20:: controller
- 21:: first output terminal
- 22:: input terminal
- 30:: power source
- 31:: second output terminal
- 40:: input/output circuit
- 41:: NOT circuit
- 42:: pull-up resistor
- 43:: transistor
- 44:: OR circuit

## Claims

1. A servo control device comprising:
a controller that controls a target device in accordance with a control program; and
a power source that supplies power to the controller,
wherein the controller includes:
a first output terminal that outputs a first signal when an appropriate control program is written, and outputs a second signal when an inappropriate control program is written;
an input/output circuit that receives the second signal and outputs an error signal when the second signal is output from the first output terminal; and
an input terminal to which an output signal from the input/output circuit is input, and
the controller is configured not to perform the control of the target device when the error signal is input to the input terminal.

2. The servo control device according to Claim 1,
wherein the power source includes a second output terminal that outputs a normality signal when the target device and the servo control device are operating properly, and outputs an anomaly signal when an anomaly occurs in at least one of the target device or the servo control device, and
wherein the input/output circuit is configured to receive the anomaly signal and to output the error signal when the anomaly signal is output from the second output terminal.

3. The servo control device according to Claim 2,
wherein the input/output circuit is configured to, when the first signal is output from the first output terminal and the normality signal is output from the second output terminal, receive the first signal and the normality signal, and to output a non-error signal, and
wherein the controller is configured to permit control of the target device when the non-error signal is input to the input terminal.

4. The servo control device according to Claim 3,
wherein each of the first signal, the error signal, and the anomaly signal is a high-level signal having a signal level higher than a predetermined level,
wherein each of the second signal, the non-error signal, and the normality signal is a low-level signal having a signal level lower than a predetermined level, and
wherein the input/output circuit includes:
an NOT circuit that receives an output signal from the first output terminal, inverts a level of the output signal from the first output terminal, and outputs the inverted signal; and
an OR circuit to which an output signal from the NOT circuit and an output signal from the second output terminal are input, with the OR circuit outputting the error signal when at least one of the output signals is the high-level signal, and outputting the non-error signal when both of the output signals are the low-level signals.

5. The servo control device according to any one of Claims 1 to 4,
wherein the appropriate control program is a control program of a predetermined version or a version later than the predetermined version, and
wherein the inappropriate control program is a control program of a version prior to the predetermined version.
